# DEMANDE DE BREVET EUROPEEN

(11) **EP 1 736 994 A1**
(43) Date de publication de la demande: **27.12.2006**
(21) Numéro de dépôt: 05291369.6
(22) Date de dépôt: 24.06.2005
(51) Int. Cl.: G11C 16/08, G11C 8/12

(54) **Mémoires à empilement pour microprocesseur avec moyen d'adressage amélioré**

(71) Demandeur: Axalto S.A., 92120 Montrouge (FR)
(72) Inventeur: Thill, Michel, c/o Axalto S.A., 78431 Louveciennes Cedex (FR)
(74) Mandataire: Renault, Patricia Marie Jacqueline

(57) **Abrégé**

Ensemble de circuits de mémoire, associés à un microprocesseur, chaque mémoire comportant au moins une entrée de sélection de mémoire (Chip Select - CS), reliée audit microprocesseur et permettant l'activation, l'écriture ou l'adressage dudit circuit correspondant, chaque mémoire comportant également une entrée d'adresses reliée à un bus d'adresse commun, est caractérisé en ce qu'il est prévu des moyens permettant d'identifier l'adresse d'un circuit de mémoire et ainsi de distinguer celui-ci d'un autre circuit de mémoire. Lesdits moyens d'identification sont constitués, pour chaque circuit de mémoire, de préférence de deux bits supplémentaires. Selon une variante, lesdites entrées Chip Select sont reliées ensemble, et l'on réalise une intervention sur chaque mémoire pour lui spécifier une valeur de Chip Select, soit en forçant électriquement des informations, soit par une commande spécifique envoyée à la mémoire.

## Description

La présente invention concerne un ensemble de mémoires pour micro processeur assemblées par empilement, et pourvu de moyens d'adressage ou de sélection améliorés.

Les mémoires associées à des microprocesseurs, qu'elles soient du type non volatiles (EEPROM, Flash ou autres) ou du type ROM, RAM, contiennent des informations qui sont prélevées depuis l'extérieur, ou sont aptes à recevoir et stocker des informations, en fonction des calculs et opérations demandés par le microprocesseur.

De telles mémoires sont utilisées notamment mais pas exclusivement dans le domaine des cartes à puces.

Il est nécessaire, lors des opérations ou calculs, de sélectionner la mémoire correspondant à l'information que l'on souhaite prélever, ou sur laquelle on souhaite inscrire une information donnée. La sélection de la mémoire correspondante suppose son identification, réalisée par l'intermédiaire d'une entrée dénommée Chip Select, selon la formulation anglaise couramment utilisée et connue par les spécialistes du domaine.

Par exemple, un boîtier de mémoire RAM comporte un certain nombre de registres (n) de bits (8,16 ou 32). Tous les boîtiers ne sont pas actionnés, puisque l'adresse que l'on souhaite sélectionner à un instant donné est unique et se trouve dans un seul des boîtiers. Pour sélectionner celui-ci, on utilise, en conjonction avec le bus d'adresse, l'entrée Chip Select, en abrégé : CS.

Selon une première configuration connue, les boîtiers de mémoire sont disposés à plat les uns à côté des autres et leur pattes de sortie ou d'entrée respectives d'adresses et de données sont connectées au bus d'adresses et au bus de données respectivement. Leur plot d'entrée CS est relié chacun au microprocesseur. On aboutit ainsi dans ce système connu, à un encombrement relativement important et un grand nombre de connections.

On a proposé, selon l'art antérieur, pour remédier à l'encombrement du système de mémoire à plat, d'empiler les boîtiers les uns au-dessus des autres. Les entrées / sorties d'un même type sont ainsi reliées ensemble, par des connections verticales.

Or, les entrées Chip Select (CS) ne doivent pas être reliées ensemble, afin de permettre l'adressage de façon distincte de chaque mémoire.

En conséquence, l'empilement des mémoires oblige à réaliser un câblage complexe pour la fonction Chip Select, et éviter que les entrées CS ne soient réunies ensemble.

Il existe donc un besoin d'empiler de façon simple plusieurs boîtiers mémoire, en respectant l'utilisation et le fonctionnement des entrées CHIP SELECT, sans supprimer ces dernières pour permettre l'utilisation d'autres types de conditionnement.

La présente invention se propose de résoudre ce problème, en permettant l'empilement des boîtiers mémoire tout en autorisant la fonction CHIP SELECT, et ce de façon simple et sans modification majeure des boîtiers mémoires, permettant ainsi de conserver l'avantage d'un encombrement réduit, combiné à une fonctionnalité de CHIP SELECT.

Ces avantages sont particulièrement intéressants dans le domaine des cartes à puce où le volume disponible est très réduit.

A cette fin, selon l'invention, l'ensemble de boîtiers de mémoire, associés à un microprocesseur, chaque mémoire comportant au moins une entrée de sélection de mémoire (CHIP SELECT - CS), reliée audit microprocesseur et permettant l'activation, l'écriture ou l'adressage dudit boîtier correspondant, chaque mémoire comportant également une entrée d'adresses reliée à un bus d'adresses commun, est caractérisé en ce qu'il est prévu des moyens permettant d'identifier l'adresse d'un boîtier de mémoire et ainsi de distinguer celui-ci d'un autre boîtier de mémoire.

Plus spécifiquement, lesdits moyens d'identification sont constitués, pour chaque boîtier de mémoire, d'au moins deux, de préférence d'au moins trois bits supplémentaire(s), outre ceux propres à l'adresse du boîtier de mémoire correspondant.

Ainsi, l'adresse de chaque mémoire comporte « m » bits d'adresses et « n » bits supplémentaires, « n » étant généralement égal à 2 ou 3.

L'invention permet de résoudre le problème des mémoires à empilement connues, où les connections entre les entrées CS et le microprocesseur sont isolées les unes des autres.

Dans le cas d'un tel mode dit standard, lesdits bits supplémentaires servent à la sélection du boîtier de mémoire et au démarrage de la commande déclenchée par le microprocesseur.

Selon une variante de réalisation de l'invention, dite en mode étendu, lesdites entrées CHIP SELECT - CS sont reliées ensemble.

Dans le cas du mode dit étendu, où les entrées Chip Select sont connectées ensemble, on réalise une intervention sur chaque mémoire pour lui permettre de passer en mode d'adressage étendu. Cette intervention peut être réalisée par exemple à la fin du test de la tranche (en anglais « wafer »), soit en forçant électriquement des informations, soit par une commande spécifique envoyée à la mémoire à l'occasion d'une quelconque étape de son cycle de vie. Ainsi, la mémoire passe en mode d'adressage dit étendu et on lui spécifie une valeur de Chip Select.

Ladite intervention, destinée à permettre l'utilisation en mode étendu d'un empilement de mémoires, est réalisée en fin de test. Dans le cas d'une mémoire non volatile, les 3 bits supplémentaires inclut un premier bit positionné pour indiquer le mode d'utilisation, soit standard, soit étendu, et un second et troisième bits supplémentaires qui identifient la mémoire d'adresse supplémentaire par exemple 01, 10, 11,... Un comparateur est prévu pour permettre la lecture et l'identification de ces bits supplémentaires.

En variante, l'ensemble de boîtiers de mémoire peut être conçu dès la fabrication, pour fonctionner soit en mode standard, soit étendu, sans possibilité de passage de l'un à l'autre.

L'invention sera bien comprise à la lumière de la description qui suit, à titre illustratif seulement, en référence aux dessins annexés dans lesquels :
- La figure 1 est une vue schématique de dessus, de boîtiers de mémoire, de type connu, disposés côte à côte ;
- La figure 2A est une vue schématique en perspective de boîtiers de mémoire empilés ;
- La figure 2B est une vue schématique de détail de la figure 2A, montrant les trous de passages des connections d'une mémoire à la suivante ; et
- La figure 3 est une représentation schématique des bits d'adresses et des bits supplémentaires selon l'invention pour un boîtier de mémoire.

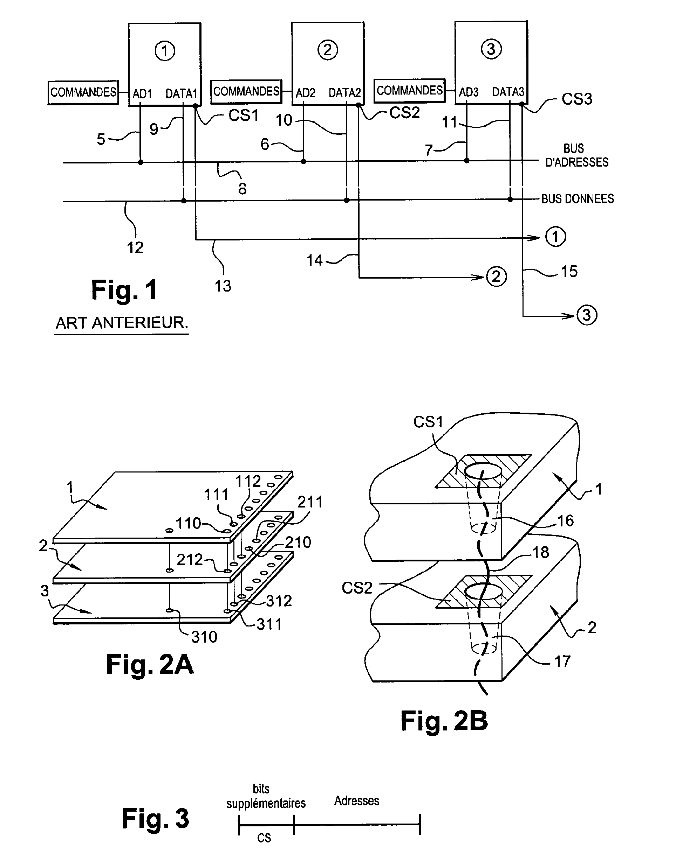

On a représenté sur la figure 1, une vue schématique de plusieurs boîtiers de mémoire, limités à trois pour la simplification du schéma, de type connu en soi et disposés côte à côte.

Les boîtiers de mémoire 1, 2 et 3 respectivement comportent un ensemble d'entrée(s) ou de sortie(s), et plus particulièrement de pattes d'entrée ou de sortie, seules certaines d'entre elles étant représentées, à savoir une patte schématisant l'ensemble des commandes, une patte référencée AD pour les adresses et une patte référencée DATA, pour les données, et enfin une patte dite CS (pour Chip select) et destinée à la sélection du boîtier mémoire correspondant. L'entrée de sélection de mémoire CS permet l'activation, l'écriture ou l'adressage du boîtier correspondant.

Il en est de même pour les boîtiers 2 et 3, et l'ensemble des boîtiers mémoires associés à un microprocesseur (non représenté). Les pattes respectives portent dans leurs références, le numéro du boîtier de mémoire correspondant, à savoir AD1, AD2, AD3 ; DATA1, DATA2, DATA3 et CS1, CS2, CS3.

Les pattes AD1, AD2 et AD3 (entrées/sorties d'adresses) sont reliées par des liaisons respectives 5, 6 et 7, à un bus commun d'adresses 8.

Les pattes DATA1, DATA2 et DATA3 (entrées/sorties de données) sont reliées par des liaisons respectives 9, 10 et 11, à un bus de données 12.

Les pattes CS1, CS2 et CS3 (chip select) sont respectivement reliées par des liaisons 13,14 et 15 au microprocesseur (non représenté).

Cette disposition de l'art antérieur consomme beaucoup de place et est complexe à mettre en place, compte tenu du grand nombre de liaisons et de la disposition côte à côte des boîtiers de mémoire.

On a proposé, toujours selon l'art antérieur, d'empiler les boîtiers de mémoires les uns au-dessus des autres, connu sous le terme anglais « stacking », comme montré sur la figure 2A.

Celle-ci montre de façon très schématique, un ensemble de circuits mémoires empilés les uns sur les autres, et représentés chacun par un rectangle, étant entendu que les proportions, notamment l'épaisseur et l'éloignement des circuits les uns par rapport aux autres ne sont pas respectées pour des raisons de clarté. Seuls trois circuits mémoires ont été représentés pour commodité, mais un plus grand nombre peut être prévu. Les circuits mémoire 1, 2 et 3 sont pourvus chacun, sur leur bord, de trous traversants 110, 111, 112 ; 210, 211, 212 ; et 310, 311, 312, pour relier ensemble et au bus correspondant (non représenté), d'un circuit au suivant, les plots ou pattes d'entrée ou de sortie du même type (adresses, données, horloge,.....).

Le problème avec l'empilement des circuits mémoires est de maintenir séparées les connexions liées à chaque patte d'entrée CS (Chip select) de chacun des circuits, compte tenu de la disposition empilée des circuits mémoires.

Des artifices de câblage, non représentés sur la figure 2A, sont nécessaires de façon connue pour tenter de palier à cet inconvénient. Ces câblages sont difficiles à mettre en place et donc augmentent le coût de revient.

La figure 2B est une vue schématique à une échelle agrandie d'une forme de réalisation de l'invention, montrant partiellement deux mémoires 1 et 2, pourvues chacune d'un trou traversant respectivement 16, 17, disposés à l'endroit des pattes d'entrée CS1 et CS2 respectivement.

Une liaison filaire 18 relie ensemble les pattes CS1, CS2 et ces dernières au microprocesseur (non représenté).

Ainsi, selon l'invention, les pattes d'entrée de Chip Select, CS1, CS2, CS3, ... sont reliées ensemble par une connexion commune 18.

De cette manière, la présente invention permet de simplifier le packaging tout en offrant un coût très faible pour les modifications requises.

Afin de permettre la sélection du circuit d'adresse correspondant, il est prévu selon l'invention des moyens d'identification de ces derniers.

En référence à la figure 3, on a représenté de façon schématique un certain nombre de bits d'adresses, associés à chaque circuit.

Selon l'invention, il est prévu deux, trois ou plusieurs bits d'adresses supplémentaires et propres à chaque entrée CS1, CS2, CS3 ...

Les circuits mémoires sont identifiés par exemple par ces bits supplémentaires selon le tableau d'exemple ci-dessous.

| CS | adresse |
|---|---|
| 1 | 01 |
| 2 | 10 |
| 3 | 11 |

Pour une application usuelle, par exemple dans le domaine des cartes à puce, une identification d'adresse comporte 20 bits et on prévoit 2 bits d'adressage supplémentaires pour chaque CSi (i=1,2,3...).

L'invention permet deux modes de fonctionnement.

Selon un premier mode dit standard, l'invention s'applique aux mémoires empilées, de conception physique connue, avec les connections entre les entrées CS et le microprocesseur isolées les unes des autres.

Les bits supplémentaires d'adresse permettent alors de sélectionner le circuit de mémoire et de déclencher la commande demandée par le microprocesseur. Les bits supplémentaires ne sont pas analysés par la mémoire.

Selon un second mode dit étendu, les entrées CS sont reliées ensemble (figure 2b).

Il est prévu préalablement une intervention sur chaque mémoire pour lui permettre de passer en mode d'adressage étendu.

Par exemple, une fois le test de tranche (en anglais « wafer ») terminé, soit on impose électriquement des informations, soit on envoie une commande spécifique à la mémoire (à un moment quelconque). Ainsi, la mémoire passe en mode d'adressage dit étendu et on lui spécifie une valeur de Chip Select.

Dans le cas d'une mémoire non volatile, les trois bits supplémentaires incluent un premier bit positionné pour indiquer le mode d'utilisation, soit standard, soit étendu, et deux bits supplémentaires qui identifient la mémoire d'adresse supplémentaire par exemple 01, 10, 11,... Un comparateur est prévu pour permettre la lecture et l'identification de ces bits supplémentaires.

En variante, l'ensemble de circuits de mémoire peut être conçu dès la fabrication, pour fonctionner soit en mode standard, soit étendu, sans possibilité de passage de l'un à l'autre.

## Revendications

1. Ensemble de circuits mémoire, associés à un microprocesseur, chaque mémoire comportant au moins une entrée de sélection de mémoire (Chip Select - CS), reliée audit microprocesseur et permettant notamment la sélection dudit circuit correspondant, **caractérisé en ce qu'**il est prévu des moyens permettant d'identifier l'adresse d'un circuit de mémoire et ainsi de distinguer celui-ci d'un autre circuit de mémoire.

2. Ensemble selon la revendication 1, **caractérisé en ce que** lesdits moyens d'identification sont constitués, pour chaque circuit de mémoire, d'au moins deux, de préférence d'au moins trois bits supplémentaire(s), outre ceux propres à l'adresse du circuit de mémoire correspondant.

3. Ensemble selon la revendication 2, **caractérisé en ce que** l'adresse de chaque mémoire comporte « m » bits d'adresses et « n » bits supplémentaires, « n » étant de préférence égal à 3.

4. Ensemble selon l'une des revendications précédentes, **caractérisé en ce que** lesdites entrées Chip Select - CS sont reliées ensemble.

5. Ensemble selon la revendication 4, **caractérisé en ce que** l'on réalise une intervention sur chaque mémoire pour lui spécifier une valeur de Chip Select.

6. Ensemble selon la revendication 5, **caractérisé en ce que** ladite intervention est réalisée à la fin du test de la tranche (en anglais « wafer »), soit en forçant électriquement des informations, soit par une commande spécifique envoyée à la mémoire.

7. Ensemble selon les revendications 2 et 4, **caractérisé en ce que** les mémoires étant non volatiles, les bits supplémentaires incluent un premier bit positionné pour indiquer le mode d'utilisation de la mémoire (soit standard, soit étendu), et un ou des bit(s) supplémentaire(s) qui identifie(nt) la mémoire d'adresse supplémentaire, un comparateur étant prévu pour permettre la lecture et l'identification de ces bits supplémentaires.
